# EUROPÄISCHE PATENTSCHRIFT

(11) **EP 3 479 468 B1**
(45) Veröffentlichungstag und Bekanntmachung des Hinweises auf die Patenterteilung: **08.09.2021**
(21) Anmeldenummer: 17732102.3
(22) Anmeldetag: 22.06.2017
(51) Int. Cl.: H02P 29/024, G01R 31/50

(54) **VERFAHREN UND VORRICHTUNG ZUM ÜBERPRÜFEN EINER MEHRPHASIGEN ANSCHLUSSLEITUNG UND BRÜCKENSCHALTUNG FÜR EINEN MEHRPHASIGEN ELEKTROMOTOR**
METHOD AND APPARATUS FOR CHECKING A MULTI-PHASE CONNECTING CABLE AND BRIDGE CIRCUIT FOR A MULTI-PHASE ELECTRICAL MOTOR
PROCÉDÉ ET APPAREIL PERMETTANT DE VÉRIFIER UN CÂBLE DE CONNEXION MULTIPHASE ET UN CIRCUIT DE PONT POUR UN MOTEUR ÉLECTRIQUE MULTIPHASE

(30) Priorität: 29.06.2016 DE 102016211698
(43) Veröffentlichungstag der Anmeldung: 08.05.2019
(73) Patentinhaber: Robert Bosch GmbH, 70442 Stuttgart (DE)
(72) Erfinder: KERN, Robert, 76547 Sinzheim (DE); HEYNA, Oliver, 74321 Bietigheim-Bissingen (DE)
(86) Internationale Anmeldenummer: PCT/EP2017/065352
(87) Internationale Veröffentlichungsnummer: WO 2018/001848

(56) Entgegenhaltungen:
- EP-A1- 0 848 492
- DE-A1-102015 107 622
- JP-A- H0 767 248
- US-A1- 2012 068 721

## Beschreibung

### Stand der Technik

Die Erfindung geht aus von einer Vorrichtung und einem Verfahren nach Gattung der unabhängigen Ansprüche. Gegenstand der vorliegenden Erfindung ist auch ein Computerprogramm.

Bei einem Elektromotor kann ein Steuergerät des Elektromotors durch eine Anschlussleitung mit dem Elektromotor verbunden sein. Die Anschlussleitung kann in einen Kabelbaum eines Fahrzeugs integriert sein. Durch beispielsweise mechanische, chemische und/oder thermische Einflüsse kann der Kabelbaum Schaden nehmen. Dabei kann beispielsweise die Isolierung einzelner Adern des Kabelbaums beschädigt werden, was zu Kurzschlüssen führen kann. Ebenso können Litzen einzelner Adern oder ganze Adern brechen, was zu einem erhöhten Widerstand der Leitung führt.

Für einen bestimmungsgemäßen Betrieb des Elektromotors und des Steuergeräts ist eine unbeschädigte Anschlussleitung erforderlich.

JP H07 67248 A offenbart ein Verfahren zum Überprüfen einer mehrphasigen Anschlussleitung zum Verbinden einer Brückenschaltung mit einem Elektromotor.

DE 10 2015 107622 A1 offenbart einen Dreiphasenwechselrichter, welcher Schaltelemente aufweist und Gleichstrom in Wechselstrom umwandelt. Eine Wechselrichterschaltbefehlseinheit ist konfiguriert, um einen Befehl zum Ausführen einer Vielzahl von Schaltmustern auszugeben, in denen das Schalten der Schaltelemente selektiv ausgeführt wird, so dass ein Strom zwischen zwei ausgewählten Phasen fließt. Eine Stromanalyseeinheit ist konfiguriert, um erfasste Ströme zu analysieren und eine Fehlerteilbestimmungseinheit ist konfiguriert, um einen fehlerhaften Teil auf der Grundlage der Stromanalyseergebnisse und der Schaltmuster zu bestimmen.

EP 0 848 492 A1 offenbart ein Verfahren zum Diagnostizieren einer Abnormalität eines Schaltungsteils einer Treibersteuerung eines Inverters zum Betreiben eines Motors.

US 2012/068721 A1 offenbart ein Verfahren zum Auswerten vom Motorströmen zur Fehlererkennung.

### Offenbarung der Erfindung

Die Erfindung wird durch ein Verfahren nach Anspruch 1 zum Überprüfen einer mehrphasigen Anschlussleitung zum Verbinden einer Brückenschaltung mit einem Elektromotor definiert. Die abhängigen Ansprüche definieren vorteilhafte Ausgestaltungen des erfindungsgemäßen Verfahrens sowie eine entsprechende Vorrichtung nach Anspruch 10, eine Brückenschaltung nach Anspruch 11, ein Computerprogramm nach Anspruch 12 und ein maschinenlesbares Speichermedium nach Anspruch 13.

Elektrische Leitungen können durch eine Bestromung überprüft werden. Insbesondere in einem Fahrzeug, bei dem eine Karosserie auf dem Massepotenzial liegt, können Kurzschlüsse und/oder Kriechströme durch ein Anlegen einer Spannung detektiert werden. Dabei verbindet die Leitung jedoch elektrische Bauelemente, die über diese Leitung versorgt werden oder kommunizieren.

Bei dem hier vorgestellten Ansatz werden die Phasen einer Anschlussleitung eines Elektromotors zum Überprüfen in einer Weise bestromt, wie sie es im laufenden Betrieb normalerweise nicht werden. Dadurch können beispielsweise Kurzschlüsse und/oder Kriechströme auch zwischen den einzelnen Phasen erkannt werden.

Ein Verfahren zum Überprüfen einer mehrphasigen Anschlussleitung zum Verbinden einer Brückenschaltung mit einem Elektromotor umfasst die folgenden Schritte:
Schalten zumindest eines Schaltmusters von zumindest zwei Schaltern der Brückenschaltung, wobei als erster Schalter des Schaltmusters ein mit einer ersten Phase der Anschlussleitung verbundener erster Highsideschalter der Brückenschaltung und als zweiter Schalter des Schaltmusters ein mit einer zweiten Phase der Anschlussleitung verbundener zweiter Lowsideschalter der Brückenschaltung eingeschaltet werden;
Messen eines durch das Schaltmuster resultierenden Stromflusses; und
Erkennen eines Schadens der Anschlussleitung unter Verwendung eines Werts des zumindest einen Stromflusses,

wobei im Schritt des Schaltens zum Umkehren einer Stromrichtung des Stromflusses in den Phasen als weiteres Schaltmuster ein mit der zweiten Phase verbundener zweiter Highsideschalter der Brückenschaltung und ein mit der ersten Phase verbundener erster Lowsideschalter der Brückenschaltung eingeschaltet werden, und bei dem im Schritt des Messens ein durch das weitere Schaltmuster resultierender weiterer Stromfluss gemessen wird,
wobei im Schritt des Erkennens ferner der weitere Stromfluss verwendet wird, um den Schaden zu erkennen,
wobei weiterhin vor Durchführung einer Unterbrechungsdiagnose der Anschlussleitung eine Rotorlagenerkennung ausgeführt wird, und
wobei bei bekannter Rotorlage ermittelt wird, welche Phasenbestromung des Elektromotors (102) kein Drehmoment im Elektromotor (102) hervorruft, und die Unterbrechungsdiagnose durch Auswahl des Schaltmusters auf der Grundlage dieser so ermittelten Phasenbestromung durchgeführt wird.

Unter einer Anschlussleitung kann ein Kabelbaum mit einer Mehrzahl an einzelnen Kabeln verstanden werden. Ebenso kann die Anschlussleitung ein mehradriges Kabel sein. In der Anschlussleitung sind alle Phasen des Elektromotors gebündelt. Eine Brückenschaltung kann Leistungselektronik zum Schalten einer Betriebsspannung des Elektromotors und Steuerelektronik zum Ansteuern der Leistungselektronik umfassen. Die Leistungselektronik umfasst dabei pro Phase zumindest zwei Schalter. Ein Schalter kann ein mechanischer Schalter, wie ein Relais sein. Ebenso kann der Schalter ein Halbleiterbauteil, wie beispielsweise ein Transistor sein. Ein elektrisch leitend Schalten kann als Einschalten bezeichnet werden. Einer der Schalter kann als Highsideschalter bezeichnet werden und ist zwischen einem Spannungspotenzial und der Phase angeordnet. Der andere Schalter kann als Lowsideschalter bezeichnet werden und ist zwischen der Phase und einem Massepotenzial angeordnet. Wenn der Highsideschalter leitend geschaltet ist, ist die Phase mit dem Spannungspotenzial leitend verbunden. Wenn der Lowsideschalter leitend geschaltet ist, ist die Phase mit dem Massepotenzial leitend verbunden. An einer Phase kann entweder der Highsideschalter oder der Lowsideschalter leitend geschaltet sein. Ein Schaltmuster kann eine Kombination von leitend geschalteten Schaltern und von nichtleitend geschalteten Schaltern sein. Ein Messen kann durch eine Messeinrichtung erfolgen. Dabei kann ein Stromfluss in einem Stromsignal abgebildet werden. Eine Unterbrechung einer bestromten Phase kann erkannt werden, wenn der Stromfluss geringer ist, als ein erwarteter Stromfluss. Insbesondere durch ein Ausbleiben des Stromflusses kann die Unterbrechung erkannt werden. Ein Kurzschluss kann durch einen Stromfluss erkannt werden, der größer als ein erwarteter Stromfluss ist.

Als weiteres Schaltmuster können ein mit der zweiten Phase verbundener zweiter Highsideschalter der Brückenschaltung und ein mit der ersten Phase verbundener erster Lowsideschalter der Brückenschaltung eingeschaltet werden. Ein durch das weitere Schaltmuster resultierender weiterer Stromfluss kann gemessen werden. Der weitere Stromfluss kann verwendet werden, um den Schaden zu erkennen. Durch ein Umschalten kann eine Stromrichtung in den Phasen umgekehrt werden. Dadurch kann eine eventuell ausgelöste Bewegung des Elektromotors kompensiert werden.

Als weiteres Schaltmuster können der erste Highsideschalter und ein mit einer dritten Phase der Anschlussleitung verbundener dritter Lowsideschalter der Brückenschaltung eingeschaltet werden. Ein durch das weitere Schaltmuster resultierender weiterer Stromfluss kann gemessen werden. Der weitere Stromfluss kann verwendet werden, um den Schaden zu erkennen. Durch nur zwei Schaltmuster können alle drei Phasen der Anschlussleitung schnell und einfach bestromt werden.

Als weiteres Schaltmuster können der erste Highsideschalter und der zweite Highsideschalter eingeschaltet werden. Ein durch das weitere Schaltmuster resultierender weiterer Stromfluss kann gemessen werden. Der weitere Stromfluss kann verwendet werden, um den Schaden zu erkennen. Durch ein Verbinden der beiden Phasen mit dem Spannungspotenzial kann ein Kurzschluss gegen Masse einfach erkannt werden. Durch den Elektromotor fließt dabei kein Strom.

Als dritter Schalter des weiteren Schaltmusters kann ferner ein mit der dritten Phase der Anschlussleitung verbundener dritter Highsideschalter der Brückenschaltung eingeschaltet werden. Bei einem dreiphasigen Elektromotor können alle drei Phasen mit dem Spannungspotenzial verbunden werden.

Als weiteres Schaltmuster können der erste Lowsideschalter und der zweite Lowsideschalter eingeschaltet werden. Ein durch das weitere Schaltmuster resultierender weiterer Stromfluss kann gemessen werden. Der weitere Stromfluss kann verwendet werden, um den Schaden zu erkennen. Durch ein Verbinden der beiden Phasen mit dem Massepotenzial kann ein Kurzschluss gegen eine auf dem Spannungspotenzial liegende andere Leitung oder ein auf dem Spannungspotenzial liegendes Bauteil erkannt werden.

Als dritter Schalter des weiteren Schaltmusters kann ferner der dritte Lowsideschalter eingeschaltet werden. Bei einem dreiphasigen Elektromotor können alle drei Phasen mit dem Massepotenzial verbunden werden.

Ein Überstrom-Erkennungsschwellenwert kann auf einen Messschwellenwert eingestellt werden. Durch einen niedrigeren Schwellenwert können auch Kriechströme erkannt werden.

Vor und/oder nach dem Schalten des zumindest einen Schaltmusters können die Schalter der Brückenschaltung ausgeschaltet werden. Durch ein allgemeines Ausschalten kann die Brückenschaltung zurückgesetzt werden. Damit ist die Anschlussleitung potenzialfrei.

Das Schaltmuster kann unter Verwendung eines, eine Rotorlage des Elektromotors abbildenden Rotorlagesignals ausgewählt werden. Durch ein Berücksichtigen der Rotorlage können die Phasen so bestromt werden, dass im Elektromotor kein Drehmoment hervorgerufen wird. Dadurch kann die Anschlussleitung überprüft werden, ohne dass sich der Rotor des Elektromotors bewegt.

Dieses Verfahren kann beispielsweise in Software oder Hardware oder in einer Mischform aus Software und Hardware beispielsweise in einem Steuergerät implementiert sein.

Der hier vorgestellte Ansatz schafft ferner eine Vorrichtung, die ausgebildet ist, um die Schritte einer Variante eines hier vorgestellten Verfahrens in entsprechenden Einrichtungen durchzuführen, anzusteuern bzw. umzusetzen. Auch durch diese Ausführungsvariante der Erfindung in Form einer Vorrichtung kann die der Erfindung zugrunde liegende Aufgabe schnell und effizient gelöst werden.

Hierzu kann die Vorrichtung zumindest eine Recheneinheit zum Verarbeiten von Signalen oder Daten, zumindest eine Speichereinheit zum Speichern von Signalen oder Daten, zumindest eine Schnittstelle zu einem Sensor oder einem Aktor zum Einlesen von Sensorsignalen von dem Sensor oder zum Ausgeben von Daten- oder Steuersignalen an den Aktor und/oder zumindest eine Kommunikationsschnittstelle zum Einlesen oder Ausgeben von Daten aufweisen, die in ein Kommunikationsprotokoll eingebettet sind. Die Recheneinheit kann beispielsweise ein Signalprozessor, ein Mikrocontroller oder dergleichen sein, wobei die Speichereinheit ein Flash-Speicher, ein EPROM oder eine magnetische Speichereinheit sein kann. Die Kommunikationsschnittstelle kann ausgebildet sein, um Daten drahtlos und/oder leitungsgebunden einzulesen oder auszugeben, wobei eine Kommunikationsschnittstelle, die leitungsgebundene Daten einlesen oder ausgeben kann, diese Daten beispielsweise elektrisch oder optisch aus einer entsprechenden Datenübertragungsleitung einlesen oder in eine entsprechende Datenübertragungsleitung ausgeben kann.

Unter einer Vorrichtung kann vorliegend ein elektrisches Gerät verstanden werden, das Sensorsignale verarbeitet und in Abhängigkeit davon Steuer- und/oder Datensignale ausgibt. Die Vorrichtung kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen der Vorrichtung beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Weiterhin wird eine Brückenschaltung für einen mehrphasigen Elektromotor vorgestellt, die zumindest einen mit einer ersten Phase verbundenen ersten Highsideschalter, einen mit einer zweiten Phase verbundenen zweiten Highsideschalter, einen mit der ersten Phase verbundenen ersten Lowsideschalter einen mit der zweiten Phase verbundenen zweiten Lowsideschalter und eine Vorrichtung gemäß dem hier vorgestellten Ansatz aufweist.

Von Vorteil ist auch ein Computerprogrammprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann und zur Durchführung, Umsetzung und/oder Ansteuerung der Schritte des Verfahrens nach einer der vorstehend beschriebenen Ausführungsformen verwendet wird, insbesondere wenn das Programmprodukt oder Programm auf einem Computer oder einer Vorrichtung ausgeführt wird.

Ausführungsbeispiele des hier vorgestellten Ansatzes sind in den Zeichnungen dargestellt und in der nachfolgenden Beschreibung näher erläutert. Es zeigt:
Fig. 1 eine Darstellung einer über eine mehrphasige Anschlussleitung mit einem mehrphasigen Elektromotor verbundenen Brückenschaltung gemäß einem Ausführungsbeispiel;
Fig. 2 eine Darstellung einer Vorrichtung zum Überprüfen einer mehrphasigen Anschlussleitung gemäß einem Ausführungsbeispiel; und
Fig. 3 ein Ablaufdiagramm eines Verfahrens zum Überprüfen einer mehrphasigen Anschlussleitung gemäß einem Ausführungsbeispiel.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

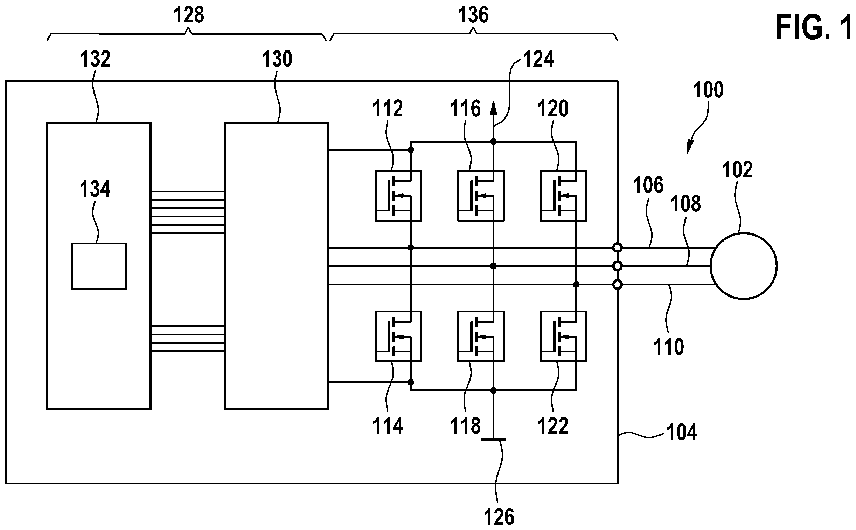

Fig. 1 zeigt eine Darstellung einer mehrphasigen Anschlussleitung 100 die einen mehrphasigen Elektromotor 102 mit einer Brückenschaltung 104 verbindet gemäß einem Ausführungsbeispiel. Der Elektromotor 102, die Anschlussleitung 100 und die Brückenschaltung 104 sind dreiphasig ausgeführt. Dabei ist die Brückenschaltung 104 über eine, auf einer ersten Ader der Anschlussleitung 100 liegende, erste Phase 106, eine, auf einer zweiten Ader der Anschlussleitung 100 liegenden, zweiten Phase 108 und eine, auf einer dritten Ader der Anschlussleitung 100 liegenden, dritten Phase 110 mit dem Elektromotor 102 verbunden. Die Brückenschaltung 104 weist pro Phase 106, 108, 110 je zwei Schaltelemente 112, 114, 116, 118, 120, 122 auf. Dabei ist je ein Highsideschalter 112, 116, 120 zwischen der jeweiligen Phase 106, 108, 110 und einem Spannungspotenzial 124 einer Versorgungsspannung angeordnet. Je ein Lowsideschalter 114, 118, 122 ist zwischen der jeweiligen Phase 106, 108, 110 und einem Massepotenzial 126 angeordnet.

Eine Ansteuerungselektronik 128 der Brückenschaltung 104 ist über hier nicht dargestellte Steuerleitungen mit den Schaltelementen 112, 114, 114, 116, 118, 120, 122 verbunden. Weiterhin ist die Ansteuerungselektronik 128 mit den drei Phasen 106, 108, 110 und den Spannungspotenzialen 124, 126 verbunden. Die Ansteuerungselektronik 128 ist hier in einen Brückentreiber 130 und einen Mikrocontroller 132 aufgeteilt dargestellt. Die Ansteuerungselektronik 128 kann auch in einem einzelnen Bauelement angeordnet sein. Der Brückenreiber 130 ist hier dazu ausgebildet, Steuersignale zum Ansteuern der Schaltelemente 112, 114, 116, 118, 120, 122 bereitzustellen und einen resultierenden Stromfluss zwischen den Spannungspotenzialen 124, 126 zu erfassen.

Der Mikrocontroller 132 umfasst hier eine Vorrichtung 134 zum Überprüfen der Anschlussleitung 100 gemäß einem Ausführungsbeispiel der vorliegenden Erfindung. Die Vorrichtung 134 ist dazu ausgebildet, ein Verfahren zum Überprüfen der Anschlussleitung 100 unter Verwendung der Ansteuerungselektronik 128 und der Schaltelemente 112, 114, 116, 118, 120, 122 anzusteuern. Dabei werden die Schaltelemente 112, 114, 116, 118, 120, 122 in verschiedenen Schaltmustern angesteuert und der jeweils resultierende Stromfluss erfasst. Je nachdem, ob ein Stromfluss resultiert, oder nicht, kann auf einen bestimmten Schaden der Anschlussleitung 100 geschlossen werden. Als Schadensarten können insbesondere Kurzschlüsse zwischen den einzelnen Phasen 106, 108, 110, Unterbrechungen der Phasen 106, 108, 110, Kurzschlüsse gegen Minus beziehungsweise das Massepotenzial 126 und Kurzschlüsse gegen Plus beziehungsweise das Spannungspotenzial 124 erkannt werden.

Somit wird eine Erkennung von elektrischen Fehlern bei mehrphasigen Motoren 102 ermöglicht.

Bei Steuergeräten 104 für mehrphasige elektrische Aktuatoren 102, vorzugsweise Dreiphasenmotoren 102 kann eine Leitungsdiagnose erforderlich sein. Der zwischen dem Steuergerät 104 und dem Motor 102 verbaute Kabelbaum 100 ist fehleranfällig bei mechanischer Belastung, Vibration und/oder Umwelteinflüssen. Durch die hier vorgestellte Diagnose können die Fehlerfälle, wie Kurzschluss nach Plus 124 (KSP), Kurzschluss nach Minus 126 (KSM) sowie Unterbrechung erkannt werden.

Die Dimensionierung der Fehlererkennung ist dabei so gestaltet, dass keine Fehldiagnosen auftreten.

Bei einem Dreiphasenmotor 102 können zwei der drei Motorphasen 106, 108 mit einem Pullupwiderstand versehen werden. An der dritten Motorphase 110 ist ein Pulldownwiderstand sowie eine Spannungsmessvorrichtung vorgesehen. Diese kann beispielsweise durch einen Analog-digital-Konverter (ADC) eines Mikrocontrollers realisiert sein. Der Pulldownwiderstand kann den halben Widerstandswert der Pullupwiderstände aufweisen. Im fehlerfreien Fall bilden die drei Widerstände einen Spannungsteiler, der etwa die halbe Versorgungsspannung liefert, weil die Innenwiderstände des Motors 102 vernachlässigbar klein sind im Vergleich zu den Diagnosewiderständen.

Bei der Dimensionierung der obigen Standardlösung ist der Umstand zu beachten, dass das Nutzsignal, also der durch die Diagnosewiderstände erzeugte Diagnosestrom, ein ungünstiges Verhältnis zu den Störsignalen aufweist, die insbesondere durch Leckströme der weiteren angeschlossenen Bauteile entstehen. Typischerweise besteht eine Endstufe 136 zum Ansteuern des Motors 102 aus sechs Transistoren 112, 114, 116, 118, 120, 122 sowie einer Ansteuerschaltung 130, die als Brückentreiber 130 bezeichnet werden kann, die in Summe einen erheblichen Summenleckstrom erzeugen.

Bei dem hier vorgestellten Ansatz wird das Nutzsignal, also der während der Diagnose eingeprägte Strom, wesentlich erhöht. Dies wird nicht wie bisher durch Diagnosewiderstände erreicht, sondern durch die ohnehin vorhandenen Transistoren 112, 114, 116, 118, 120, 122 und ein günstig gewähltes Ansteuerverfahren.

Dazu weist die Schaltung 104 eine Erkennung 134 bei Überschreitung eines eingestellten maximalen Transistorstroms auf. Beispielsweise kann die Erkennung durch eine Überwachung der Spannungsabfälle der eingeschalteten Transistoren 112, 114, 116, 118, 120, 122 erfolgen. Vorteilhafterweise ist die Erkennungsschwelle einstellbar und dynamisch umschaltbar, sodass für Diagnosezwecke eine andere, insbesondere eine niedrigere Auslöseschwelle eingestellt werden kann als für den normalen Motorbetrieb.

Der für die Diagnose verwendete Nutzstrom fließt durch die Transistoren 112, 114, 116, 118, 120, 122 und den Motor 102, wodurch der Gesamtwiderstand erheblich kleiner ist, als bei der Standardlösung. Der resultierende Diagnosestrom und der Abstand zu den Störsignalen sind deshalb wesentlich größer.

Für die Diagnose sind keine zusätzlichen Komponenten erforderlich, alle verwendeten Komponenten sind für den normalen Betrieb ebenfalls erforderlich.

Eine dauerhafte zusätzliche Last durch die Diagnosewiderstände entfällt. Somit resultiert auch keine unerwünschte zusätzliche Erwärmung, was besonders bei Steuergeräten 104 mit mehreren Motorendstufen 136 vorteilhaft ist.

Das vorgeschlagene Diagnosesystem 104 besteht zumindest aus sechs Transistoren 112, 114, 116, 118, 120, 122 (T1 bis T6) zum Schalten der drei Phasen 106, 108, 110 nach Plus oder Minus. Weiterhin weist das Diagnosesystem 104 eine Ansteuerkomponente 130 auf, die als Brückentreiber bezeichnet werden kann. Die Ansteuerkomponente 130 setzt die vom Mikrocontroller 132 kommenden Steuersignale mit SV oder 3,3V Pegel in die Ansteuerspannung für die Transistoren 112, 114, 116, 118, 120, 122 um. Eine Diagnosevorrichtung erkennt eine Stromüberschreitung in jedem Transistor 112, 114, 116, 118, 120, 122. Vorteilhafterweise sind diese sechs Schaltungen in den Brückentreiber 130 implementiert. Vorteilhafterweise ist die Auslöseschwelle dynamisch veränderbar. Der Mikrocontroller 132 und der Brückentreiber 130 sind über Steuer- und Rückmeldungsleitungen verbunden. Dabei können sechs Steuerleitungen für die sechs Transistoren 112, 114, 116, 118, 120, 122 sowie eine meist serielle Schnittstelle, beispielsweise SPI, zur Kommunikation zwischen Mikrocontroller 132 und Brückentreiber 130 verwendet werden.

Das vorgeschlagene Diagnoseverfahren besteht aus mehreren Schritten. Zur Erkennung von Kurzschlüssen werden zuerst die sechs Transistoren 112, 114, 116, 118, 120, 122 ausgeschaltet. Anschließend wird, falls vom Brückentreiber 130 unterstützt, eine Überstrom-Erkennungsschwelle auf einen niedrigeren Wert als dem normalen Betriebswert gesetzt. Beispielsweise kann die Überstrom-Erkennungsschwelle um ca. Faktor 10 reduziert werden. Dadurch können auch Fehlerströme mit geringerer Amplitude als dem normalen Betriebsstrom erkannt werden. Daraufhin werden die drei Highside-Transistoren 112, 116, 120 (T1, T3, T5) eingeschaltet. Falls ein Kurzschluss nach Minus 126 (KSM) vorliegt, wird dies anhand der Überstromerkennung erkannt. Die sechs Transistoren 112, 114, 116, 118, 120, 122 werden wieder ausgeschaltet. Dann werden die drei Lowside-Transistoren 114, 118, 122 (T2, T4, T6) eingeschaltet. Falls ein Kurzschluss nach Plus 124 (KSP) vorliegt, wird dies anhand der Überstromerkennung erkannt. Die sechs Transistoren 112, 114, 116, 118, 120, 122 werden wieder ausgeschaltet.

Zur Erkennung einer Leitungsunterbrechung wird einer der Highsidetransistoren 112, 116, 120 und ein dazu nicht komplementärer Lowsidetransistor 114, 118, 122 eingeschaltet. Beispielsweise werden 116 (T3) und 114 (T2) eingeschaltet. Bei einem fehlerfreien System 100 entsteht innerhalb kurzer Zeit, beispielsweise der elektrischen Motorzeitkonstante, ein Messstrom, der die Diagnoseschwelle überschreitet. Bei Unterbrechung der Leitung 106 (L1) oder 108 (L2) wird die Diagnoseschwelle nicht erreicht und der Fehler dadurch erkannt. Die sechs Transistoren 112, 114, 116, 118, 120, 122 werden wieder ausgeschaltet. Dann wird einer der Highsidetransistoren 112, 116, 120 und der andere nicht komplementäre Lowsidetransistor 114, 118, 122 eingeschaltet, beispielsweise 116 (T3) und 122 (T6). Bei fehlerfreiem System entsteht wieder innerhalb kurzer Zeit ein Messstrom, der die Diagnoseschwelle überschreitet. Bei Unterbrechung der Leitung 108 (L2) oder 110 (L3) wird die Diagnoseschwelle nicht erreicht und der Fehler dadurch erkannt. Die sechs Transistoren 112, 114, 116, 118, 120, 122 werden wieder ausgeschaltet. Durch Kombination der Diagnoseergebnisse ist identifizierbar, welche Phasenleitung 106, 108, 110 unterbrochen ist.

Bei diesem Ausführungsbeispiel der Unterbrechungserkennung kann es je nach gewählter Diagnoseschwelle durch den eingeprägten Teststrom zu einer unerwünschten geringfügigen Bewegung des Aktuators 102 kommen.

Zur Vermeidung beziehungsweise Kompensation dieser Bewegung können nach der erfolgten Bewegung die gleichen Phasen 106, 108, 110 entgegengesetzt bestromt werden. Ebenso kann eine Rotorlageerkennung vor Durchführung der Unterbrechungsdiagnose ausgeführt werden. Bei bekannter Rotorlage ist auch bekannt, welche Phasenbestromung nicht zu einer Bewegung führt. Genau diese Phasenbestromung wird für die Unterbrechungsdiagnose gewählt.

Bei sensorbehafteten Motoren 102, meist mit Hallsensoren, wird die Rotorlage durch die Sensoren erkannt. Bei sensorlosen Motoren 102 können andere bekannte Rotorlagen-Erkennungssysteme eingesetzt werden.

Durch eine elektrische Messung im Zeitbereich, insbesondere während des Einschaltvorgangs und des Ausschaltvorgangs kann eine bestimmungsgemäße Durchführung des hier vorgestellten Ansatzes überprüft werden.

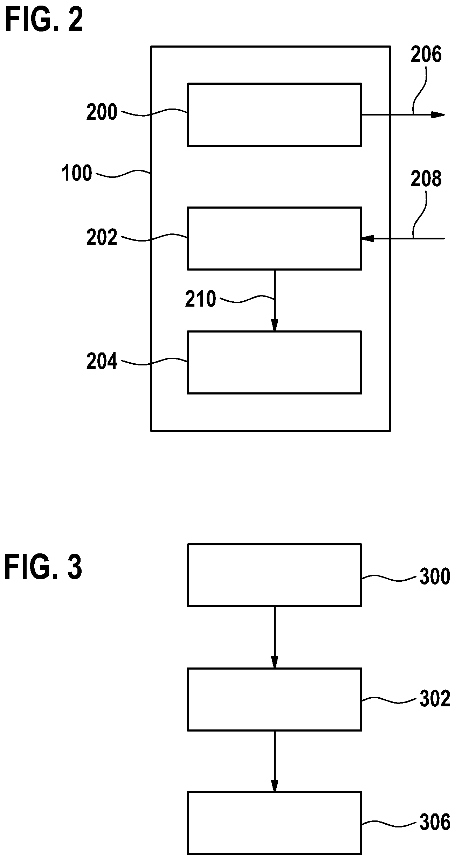

Fig. 2 zeigt ein Blockschaltbild einer Vorrichtung 134 zum Überprüfen einer mehrphasigen Anschlussleitung gemäß einem Ausführungsbeispiel. Die Vorrichtung 134 entspricht dabei im Wesentlichen der Vorrichtung in Fig. 1. Die Vorrichtung 134 weist eine Schalteinrichtung 200, eine Messungseinrichtung 202 und eine Erkennungseinrichtung 204 auf. Die Schalteinrichtung ist dazu ausgebildet, zumindest ein Schaltmuster 206 von zumindest zwei Schaltern der Brückenschaltung zu schalten, wobei als erster Schalter des Schaltmusters 208 ein mit einer ersten Phase der Anschlussleitung verbundener erster Highsideschalter der Brückenschaltung geschaltet wird. Als zweiter Schalter des Schaltmusters 206 wird ein mit einer zweiten Phase der Anschlussleitung verbundener zweiter Lowsideschalter der Brückenschaltung eingeschaltet. Die Messungseinrichtung 202 ist dazu ausgebildet, einen durch das Schaltmuster 206 resultierenden Stromfluss 208 zu messen. Die Erkennungseinrichtung 204 ist dazu ausgebildet, einen Schaden der Anschlussleitung unter Verwendung eines Werts 210 des zumindest einen Stromflusses 208 zu erkennen.

Dazu ist die Vorrichtung 134 gemäß einem Ausführungsbeispiel über geeignete Schnittstellen mit einer Brückenschaltung verbunden, sodass das Schaltmuster 206 in Form eines Steuersignals an Schalteingänge der Schalter der Brückenschaltung bereitgestellt werden kann und der Stromfluss 208 von zumindest einer mit den Schaltern gekoppelten Leitung abgegriffen werden kann.

Fig. 3 zeigt ein Ablaufdiagramm eines Verfahrens zum Überprüfen einer mehrphasigen Anschlussleitung gemäß einem Ausführungsbeispiel. Das Verfahren kann beispielsweise auf einer Vorrichtung, wie sie in den Figuren 1 und 2 dargestellt ist, ausgeführt werden. Das Verfahren weist einen Schritt 300 des Schaltens, einen Schritt 302 des Messens und einen Schritt 304 des Erkennens auf. Im Schritt 300 des Schaltens wird zumindest ein Schaltmuster von zumindest zwei Schaltern der Brückenschaltung geschaltet. Dabei wird als erster Schalter des Schaltmusters ein mit einer ersten Phase der Anschlussleitung verbundener erster Highsideschalter der Brückenschaltung eingeschaltet. Als zweiter Schalter des Schaltmusters wird ein mit einer zweiten Phase der Anschlussleitung verbundener zweiter Lowsideschalter der Brückenschaltung eingeschaltet. Im Schritt 302 des Messens wird ein durch das Schaltmuster resultierender Stromfluss gemessen. Im Schritt 302 des Erkennens wird ein Schaden der Anschlussleitung unter Verwendung eines Werts des zumindest einen Stromflusses erkannt.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Verfahren zum Überprüfen einer mehrphasigen Anschlussleitung (100) zum Verbinden einer Brückenschaltung (104) mit einem Elektromotor (102), wobei das Verfahren die folgenden Schritte aufweist:
Schalten (300) zumindest eines Schaltmusters (206) von zumindest zwei Schaltern (112, 114, 116, 118, 120, 122) der Brückenschaltung (104), wobei als erster Schalter (112, 114, 116, 118, 120, 122) des Schaltmusters (206) ein mit einer ersten Phase (106) der Anschlussleitung (100) verbundener erster Highsideschalter (112) der Brückenschaltung (104) und als zweiter Schalter (112, 114, 116, 118, 120, 122) des Schaltmusters (206) ein mit einer zweiten Phase (108) der Anschlussleitung (100) verbundener zweiter Lowsideschalter (118) der Brückenschaltung (104) eingeschaltet werden;
Messen (302) eines durch das Schaltmuster (206) resultierenden Stromflusses (208); und
Erkennen (304) eines Schadens der Anschlussleitung (100) unter Verwendung eines Werts (210) des zumindest einen Stromflusses (208),
wobei im Schritt (300) des Schaltens zum Umkehren einer Stromrichtung des Stromflusses (208) in den Phasen (106, 108) als weiteres Schaltmuster (206) ein mit der zweiten Phase (108) verbundener zweiter Highsideschalter (116) der Brückenschaltung (104) und ein mit der ersten Phase (106) verbundener erster Lowsideschalter (114) der Brückenschaltung (104) eingeschaltet werden, und bei dem im Schritt (302) des Messens ein durch das weitere Schaltmuster (206) resultierender weiterer Stromfluss (208) gemessen wird, wobei im Schritt (304) des Erkennens ferner der weitere Stromfluss (208) verwendet wird, um den Schaden zu erkennen,
**dadurch gekennzeichnet, dass**
vor Durchführung einer Unterbrechungsdiagnose der Anschlussleitung (100) eine Rotorlagenerkennung ausgeführt wird, wobei bei bekannter Rotorlage ermittelt wird, welche Phasenbestromung des Elektromotors (102) kein Drehmoment im Elektromotor (102) hervorruft, und die Unterbrechungsdiagnose durch Auswahl des Schaltmusters auf der Grundlage dieser so ermittelten Phasenbestromung durchgeführt wird.

2. Verfahren gemäß Anspruch 1, bei dem im Schritt (300) des Schaltens als weiteres Schaltmuster (206) der erste Highsideschalter (112) und ein mit einer dritten Phase (110) der Anschlussleitung (100) verbundener dritter Lowsideschalter (122) der Brückenschaltung (104) eingeschaltet werden, und bei dem im Schritt (302) des Messens ein durch das weitere Schaltmuster (206) resultierender weiterer Stromfluss (208) gemessen wird, wobei im Schritt (304) des Erkennens ferner der weitere Stromfluss (208) verwendet wird, um den Schaden zu erkennen.

3. Verfahren gemäß einem der vorangegangenen Ansprüche, bei dem im Schritt (300) des Schaltens als weiteres Schaltmuster (206) der erste Highsideschalter (112) und der zweite Highsideschalter (116) eingeschaltet werden, und bei dem im Schritt (302) des Messens ein durch das weitere Schaltmuster (206) resultierender weiterer Stromfluss (208) gemessen wird, wobei im Schritt (304) des Erkennens ferner der weitere Stromfluss (208) verwendet wird, um den Schaden zu erkennen.

4. Verfahren gemäß Anspruch 3, bei dem im Schritt (300) des Schaltens als dritter Schalter (112, 114, 116, 118, 120, 122) des weiteren Schaltmusters (206) ferner ein mit der dritten Phase (110) der Anschlussleitung (100) verbundener dritter Highsideschalter (120) der Brückenschaltung (104) eingeschaltet wird.

5. Verfahren gemäß einem der vorangegangenen Ansprüche, bei dem im Schritt (300) des Schaltens als weiteres Schaltmuster (206) der erste Lowsideschalter (114) und der zweite Lowsideschalter (118) eingeschaltet werden, und bei dem im Schritt (302) des Messens ein durch das weitere Schaltmuster (206) resultierender weiterer Stromfluss (208) gemessen wird, wobei im Schritt (304) des Erkennens ferner der weitere Stromfluss (208) verwendet wird, um den Schaden zu erkennen.

6. Verfahren gemäß Anspruch 5, bei dem im Schritt (300) des Schaltens als dritter Schalter (112, 114, 116, 118, 120, 122) des weiteren Schaltmusters (206) ferner der dritte Lowsideschalter (122) eingeschaltet wird.

7. Verfahren gemäß einem der vorangegangenen Ansprüche, **dadurch gekennzeichnet, dass** im Schritt (302) des Messens ein Überstrom-Erkennungsschwellenwert auf einen Messschwellenwert eingestellt wird und eine Unterbrechung der Anschlussleitung (100) erkannt wird, wenn der zumindest eine Stromfluss (208) oder der weitere Stromfluss (208) kleiner als der Messschwellenwert sind.

8. Verfahren gemäß einem der vorangegangenen Ansprüche, bei dem im Schritt (300) des Schaltens vor und/oder nach dem Schalten des zumindest einen Schaltmusters (206) die Schalter (112, 114, 116, 118, 120, 122) der Brückenschaltung (104) ausgeschaltet werden.

9. Verfahren gemäß einem der vorangegangenen Ansprüche, bei dem im Schritt (300) des Schaltens das Schaltmuster (206) unter Verwendung eines, eine Rotorlage des Elektromotors (102) abbildenden Rotorlagesignals ausgewählt wird.

10. Vorrichtung (134), die zumindest eine Recheneinheit zum Verarbeiten von Signalen oder Daten, zumindest eine Speichereinheit zum Speichern von Signalen oder Daten, zumindest eine Schnittstelle zu einem Sensor oder einem Aktor zum Einlesen von Sensorsignalen von dem Sensor oder zum Ausgeben von Daten- oder Steuersignalen an den Aktor und/oder zumindest eine Kommunikationsschnittstelle zum Einlesen oder Ausgeben von Daten aufweist, die in ein Kommunikationsprotokoll eingebettet sind, und zudem eingerichtet ist, um Schritte (300, 302, 304) des Verfahrens gemäß einem der vorangegangenen Ansprüche in entsprechenden Einheiten (200, 202, 204) auszuführen.

11. Brückenschaltung (104) für einen mehrphasigen Elektromotor (102), wobei die Brückenschaltung (104) zumindest einen mit einer ersten Phase (106) verbundenen ersten Highsideschalter (112), einen mit einer zweiten Phase (108) verbundenen zweiten Highsideschalter (116), einen mit der ersten Phase (106) verbundenen ersten Lowsideschalter (114) einen mit der zweiten Phase (108) verbundenen zweiten Lowsideschalter (118) und eine Vorrichtung (134) gemäß Anspruch 10 aufweist.

12. Computerprogramm, das zur Durchführung, Umsetzung und/oder Ansteuerung der Schritte des Verfahrens gemäß einem der Ansprüche 1 bis 9 eingerichtet ist, wenn es auf der Vorrichtung (134) nach Anspruch 10 ausgeführt wird.

13. Maschinenlesbares Speichermedium, auf dem das Computerprogramm nach Anspruch 12 gespeichert ist.

## Claims

1. Method for testing a multi-phase connection line (100) for connecting a bridge circuit (104) to an electric motor (102), wherein the method comprises the following steps:
switching (300) at least one switching pattern (206) by at least two switches (112, 114, 116, 118, 120, 122) of the bridge circuit (104), wherein a first high-side switch (112) of the bridge circuit (104), said switch being connected to a first phase (106) of the connection line (100), is switched on as the first switch (112, 114, 116, 118, 120, 122) of the switching pattern (206) and a second low-side switch (118) of the bridge circuit (104), said switch being connected to a second phase (108) of the connection line (100), is switched on as the second switch (112, 114, 116, 118, 120, 122) of the switching pattern (206);
measuring (302) a current flow (208) resulting from the switching pattern (206); and
detecting (304) damage to the connection line (100) using a value (210) of the at least one current flow (208),
wherein
in the switching step (300), in order to reverse a current direction of the current flow (208) in the phases (106, 108), a second high-side switch (116) of the bridge circuit (104), said switch being connected to the second phase (108), and a first low-side switch (114) of the bridge circuit (104), said switch being connected to the first phase (106), are switched on as the further switching pattern (206), and wherein, in the measuring step (302), a further current flow (208) resulting from the further switching pattern (206) is measured, wherein, in the detecting step (304), the further current flow (208) is also used to detect the damage,
**characterized in that**
a rotor position detection is performed before an interruption diagnosis of the connection line (100) is carried out, wherein, when the rotor position is known, the phase energization of the electric motor (102) that does not cause a torque in the electric motor (102) is identified, and the interruption diagnosis is carried out by selecting the switching pattern on the basis of said phase energization identified in this way.

2. Method according to Claim 1, in which, in the switching step (300), the first high-side switch (112) and a third low-side switch (122) of the bridge circuit (104), said switch being connected to a third phase (110) of the connection line (100), are switched on as the further switching pattern (206), and in which, in the measuring step (302), a further current flow (208) resulting from the further switching pattern (206) is measured, wherein, in the detecting step (304), the further current flow (208) is also used to detect the damage.

3. Method according to either of the preceding claims, in which, in the switching step (300), the first high-side switch (112) and the second high-side switch (116) are switched on as the further switching pattern (206), and in which, in the measuring step (302), a further current flow (208) resulting from the further switching pattern (206) is measured, wherein, in the detecting step (304), the further current flow (208) is also used to detect the damage.

4. Method according to Claim 3, in which, in the switching step (300), a third high-side switch (120) of the bridge circuit (104), said switch being connected to the third phase (110) of the connection line (100), is also switched on as the third switch (112, 114, 116, 118, 120, 122) of the further switching pattern (206).

5. Method according to one of the preceding claims, in which, in the switching step (300), the first low-side switch (114) and the second low-side switch (118) are switched on as the further switching pattern (206), and in which, in the measuring step (302), a further current flow (208) resulting from the further switching pattern (206) is measured, wherein, in the detecting step (304), the further current flow (208) is also used to detect the damage.

6. Method according to Claim 5, in which, in the switching step (300), the third low-side switch (122) is also switched on as the third switch (112, 114, 116, 118, 120, 122) of the further switching pattern (206).

7. Method according to one of the preceding claims, **characterized in that**, in the measuring step (302), an overcurrent detection threshold value is set to a measurement threshold value and an interruption in the connection line (100) is detected when the at least one current flow (208) or the further current flow (208) is lower than the measurement threshold value.

8. Method according to one of the preceding claims, in which, in the switching step (300), the switches (112, 114, 116, 118, 120, 122) of the bridge circuit (104) are switched off before and/or after the switching of the at least one switching pattern (206).

9. Method according to one of the preceding claims, in which, in the switching step (300), the switching pattern (206) is selected using a rotor position signal representing a rotor position of the electric motor (102) .

10. Device (134), which has at least one computation unit for processing signals or data, at least one storage unit for storing signals or data, at least one interface to a sensor or to an actuator for reading in sensor signals from the sensor or for outputting data or control signals to the actuator and/or at least one communication interface for reading in or outputting data, which are embedded in a communication protocol, and is also set up to execute steps (300, 302, 304) of the method according to one of the preceding claims in corresponding units (200, 202, 204).

11. Bridge circuit (104) for a multi-phase electric motor (102), wherein the bridge circuit (104) has at least one first high-side switch (112) connected to a first phase (106), a second high-side switch (116) connected to a second phase (108), a first low-side switch (114) connected to the first phase (106), a second low-side switch (118) connected to the second phase (108) and a device (134) according to Claim 10.

12. Computer program, which is set up to carry out, implement and/or control the steps of the method according to one of Claims 1 to 9 when said computer program is executed on the device (134) according to Claim 10.

13. Machine-readable storage medium, on which the computer program according to Claim 12 is stored.

## Revendications

1. Procédé permettant de vérifier un câble de connexion multiphase (100) pour relier un circuit en pont (104) à un moteur électrique (102), le procédé présentant les étapes suivantes consistant à :
câbler (300) au moins un schéma de câblage (206) d'au moins deux commutateurs (112, 114, 116, 118, 120, 122) du circuit en pont (104), dans lequel, comme premier commutateur (112, 114, 116, 118, 120, 122) du schéma de câblage (206), un premier commutateur côté haut (112) du circuit en pont (104), relié à une première phase (106) du câble de connexion (100), et comme deuxième commutateur (112, 114, 116, 118, 120, 122) du schéma de câblage (206), un deuxième commutateur côté bas (118) du circuit en pont (104), relié à une deuxième phase (108) du câble de connexion (100), sont mis en circuit ;
mesurer (302) un flux de courant (208) résultant du schéma de câblage (206) ; et
identifier (304) un endommagement du câble de connexion (100) en utilisant une valeur (210) de l'au moins un flux de courant (208),
dans lequel, à l'étape (300) de câblage, pour inverser un sens de courant du flux de courant (208) dans les phases (106, 108), comme autre schéma de câblage (206), un deuxième commutateur côté haut (116), relié à la deuxième phase (108), du circuit en pont (104) et un premier commutateur côté bas (114), relié à la première phase (106), du circuit en pont (104) sont mis en circuit, et dans lequel, à l'étape (302) de mesure, un autre flux de courant (208) résultant de l'autre schéma de câblage (206) est mesuré, dans lequel, à l'étape (304) d'identification, en outre l'autre flux de courant (208) est utilisé pour identifier l'endommagement,
**caractérisé en ce qu'**avant l'exécution d'un diagnostic de rupture du câble de connexion (100), une identification de position de rotor est effectuée, dans lequel, pour une position de rotor connue, il est déterminé quelle alimentation de phase du moteur électrique (102) ne provoque aucun couple dans le moteur électrique (102), et le diagnostic de rupture est effectué en sélectionnant le schéma de câblage sur la base de l'alimentation de phase ainsi déterminée.

2. Procédé selon la revendication 1, dans lequel, à l'étape (300) de câblage, comme autre schéma de câblage (206), le premier commutateur côté haut (112) et un troisième commutateur côté bas (122), relié à une troisième phase (110) du câble de connexion (100), du circuit en pont (104) sont mis en circuit, et dans lequel, à l'étape (302) de mesure, un autre flux de courant (208) résultant de l'autre schéma de câblage (206) est mesuré, dans lequel, à l'étape (304) d'identification, en outre l'autre flux de courant (208) est utilisé pour identifier l'endommagement.

3. Procédé selon l'une quelconque des revendications précédentes, dans lequel, à l'étape (300) de câblage, comme autre schéma de câblage (206), le premier commutateur côté haut (112) et le deuxième commutateur côté haut (116) sont mis en circuit, et dans lequel, à l'étape (302) de mesure, un autre flux de courant (208) résultant de l'autre schéma de câblage (206) est mesuré, dans lequel, à l'étape (304) d'identification, en outre l'autre flux de courant (208) est utilisé pour identifier l'endommagement.

4. Procédé selon la revendication 3, dans lequel, à l'étape (300) de câblage, comme troisième commutateur (112, 114, 116, 118, 120, 122) de l'autre schéma de câblage (206), en outre un troisième commutateur côté haut (120), relié à la troisième phase (110) du câble de connexion (100), du circuit en pont (104) est mis en circuit.

5. Procédé selon l'une quelconque des revendications précédentes, dans lequel, à l'étape (300) de câblage, comme autre schéma de câblage (206), le premier commutateur côté bas (114) et le deuxième commutateur côté bas (118) sont mis en circuit, et dans lequel, à l'étape (302) de mesure, un autre flux de courant (208) résultant de l'autre schéma de câblage (206) est mesuré, dans lequel, à l'étape (304) d'identification, en outre l'autre flux de courant (208) est utilisé pour identifier l'endommagement.

6. Procédé selon la revendication 5, dans lequel, à l'étape (300) de câblage, comme troisième commutateur (112, 114, 116, 118, 120, 122) de l'autre schéma de câblage (206), en outre le troisième commutateur côté bas (122) est mis en circuit.

7. Procédé selon l'une quelconque des revendications précédentes, **caractérisé en ce qu'**à l'étape (302) de mesure, une valeur seuil d'identification de surintensité de courant est réglée sur une valeur seuil de mesure, et une rupture du câble de connexion (100) est identifiée si ledit au moins un flux de courant (208) ou l'autre flux de courant (208) est inférieur à la valeur seuil de mesure.

8. Procédé selon l'une quelconque des revendications précédentes, dans lequel, à l'étape (300) de câblage avant et/ou après le câblage de l'au moins un schéma de câblage (206), les commutateurs (112, 114, 116, 118, 120, 122) du circuit en pont (104) sont mis hors circuit.

9. Procédé selon l'une quelconque des revendications précédentes, dans lequel, à l'étape (300) de câblage, le schéma de câblage (206) est sélectionné en utilisant un signal de position de rotor représentant une position de rotor du moteur électrique (102).

10. Dispositif (134) qui présente au moins une unité arithmétique permettant de traiter des signaux ou des données, au moins une unité de stockage pour stocker des signaux ou des données, au moins une interface avec un capteur ou un actionneur pour lire des signaux de capteur provenant du capteur ou pour sortir des signaux de données ou de commande à destination de l'actionneur, et/ou au moins une interface de communication pour lire ou sortir des données qui sont incorporées dans un protocole de communication, et qui est en outre aménagée pour effectuer des étapes (300, 302, 304) du procédé selon l'une quelconque des revendications précédentes dans des unités (200, 202, 204) correspondantes.

11. Circuit en pont (104) destiné à un moteur électrique multiphase (102), le circuit en pont (104) présentant au moins un premier commutateur côté haut (112) relié à une première phase (106), un deuxième commutateur côté haut (116) relié à une deuxième phase (108), un premier commutateur côté bas (114) relié à la première phase (106), un deuxième commutateur côté bas (118) relié à la deuxième phase (108) et un dispositif (134) selon la revendication 10.

12. Programme informatique qui est aménagé pour l'exécution, la mise en œuvre et/ou le pilotage des étapes du procédé selon l'une quelconque des revendications 1 à 9 lorsqu'il est exécuté sur le dispositif (134) selon la revendication 10.

13. Support de stockage lisible par machine, sur lequel est stocké le programme informatique selon la revendication 12.
